# FASCICULE DE BREVET EUROPEEN

(11) **EP 2 071 058 B1**
(45) Date de publication et mention de la délivrance du brevet: **13.07.2011**
(21) Numéro de dépôt: 08354088.0
(22) Date de dépôt: 28.11.2008
(51) Int. Cl.: C30B 13/00, C30B 13/24, C30B 29/06, H01L 21/20, H01L 21/77

(54) **Procédé de cristallisation**
Kristallisierungsverfahren
Crystallisation method

(30) Priorité: 28.11.2007 WO PCT/FR2007/001965
(43) Date de publication de la demande: 17.06.2009
(73) Titulaire: Commissariat à l'Énergie Atomique et aux Énergies Alternatives, 75015 Paris (FR)
(72) Inventeur: Bouchut, Philippe, 38340 Voreppe (FR)
(74) Mandataire: Hecké, Gérard

(56) Documents cités:
- US-A1- 2004 137 671
- US-A1- 2004 142 543
- US-A1- 2006 267 073
- US-B1- 6 278 130
- US-B1- 7 192 818
- HU G-R ET AL: "GROWTH MECHANISM OF LASER ANNEALING OF NICKEL-INDUCED LATERAL CRYSTALLIZED SILICON FILMS" JAPANESE JOURNAL OF APPLIED PHYSICS, JAPAN SOCIETY OF APPLIED PHYSICS, TOKYO.; JP, vol. 45, no. 1A, 1 janvier 2006 (2006-01-01), pages 21-27, XP001245550 ISSN: 0021-4922

## Description

### Domaine technique de l'invention

L'invention concerne un procédé de cristallisation.

### État de la technique

Il existe de nombreuses méthodes de cristallisation : la cristallisation d'un matériau à partir de sa phase vapeur, la cristallisation à partir de bains fondus ou la cristallisation à partir de solutions. Dans ces cas, le cristal apparaît par refroidissement lors de la transition liquide-solide ou lors de la transition vapeur-solide.

Plus particulièrement, des matériaux cristallisés sous une forme monocristalline peuvent être obtenus par croissance à partir d'un germe monocristallin. À titre d'exemple, des lingots en silicium monocristallin peuvent être obtenus par le procédé de Czochralski qui consiste à tremper un germe monocristallin, à la surface d'un bain de silicium faiblement surchauffé et à tirer le germe à vitesse continue. La solidification a lieu et reproduit le motif cristallin du germe jusqu'à l'obtention d'un lingot en silicium monocristallin. Le bain de silicium est contenu dans un creuset qui doit être formé par un matériau ayant un point de fusion supérieur à celui du silicium monocristallin. Il est, par exemple, en silice ou en nitrure de bore. Or, plus la température de fusion du monocristal est élevée, plus le volume de cristal est important, plus le coût du creuset devient prohibitif. De plus, il faut maintenir le bain liquide à la température de fusion pendant toute la durée de croissance du cristal, ce qui nécessite un apport énergétique important et contrôlé sur de longues périodes de temps. Enfin, les procédés actuels de cristallisation ne sont pas adaptés pour réaliser des cristaux sur de grandes surfaces.

De plus, dans le cas d'un lingot de silicium monocristallin, obtenu par procédé de Czochralski, celui-ci doit subir un certain nombre d'étapes supplémentaires, avant de pouvoir être utilisé sous forme de tranches. In doit, ainsi, être conditionné, découpé, poli, nettoyé... Or, ces traitements provoquent une perte de matière et affectent les propriétés physiques de la surface du silicium monocristallin. Ainsi, dans le domaine de la microélectronique, à l'issue du conditionnement, les tranches de silicium monocristallin sont d'une épaisseur supérieure à 100 µm, afin de permettre leur préhension et leur maniement robotisé. Or, l'épaisseur utilisée pour réaliser un dispositif microélectronique ne représente qu'une très faible proportion de l'épaisseur totale de la tranche. De tels procédés de cristallisation monocristalline ne sont donc pas adaptés pour réaliser des épaisseurs nanométriques.

Des films minces polycristallins peuvent être obtenus par cristallisation, soit à partir de la phase liquide, soit à partir de la phase solide d'une couche amorphe.

À titre d'exemple, la cristallisation, sous forme polycristalline, d'une couche amorphe de silicium, déposée sur un substrat, par exemple en verre, peut être réalisée à l'aide d'un faisceau laser pulsé, principalement un laser excimère. Dans ce cas, la cristallisation est réalisée après un passage en phase liquide, c'est-à-dire par voie liquide. L'énergie du laser est, en effet, absorbée localement par la couche à cristalliser, ce qui permet de porter le matériau à haute température, tandis que le substrat reste à une température relativement basse. Le polycristal apparaît, alors, lors du cycle de fusion-solidification. Lors de la croissance, dite SLG (ou « Super Lateral Growth »), la cristallisation de la zone exposée et chauffée par le laser débute par les parties externes de ladite zone, lesdites parties étant celles qui se refroidissent le plus vite à l'intérieur de la zone chauffée par le faisceau laser.

La dimension maximale des grains obtenus par cette technique de cristallisation en voie liquide est de l'ordre de 5 à 10 fois l'épaisseur de la couche à cristalliser. Or, les couches ont, en général, une épaisseur de quelques centaines de nanomètres d'épaisseur. Ainsi, cette technique s'applique, en général, à des couches très minces. De plus, c'est une technique difficile à mettre en oeuvre pour cristalliser une grande surface de façon homogène.

Pour remédier à cet inconvénient, la demande de brevet JP-A-61 068385 propose, par exemple, de déposer une couche mince en silicium à cristalliser, sur une couche intermédiaire en silice structurée. Dans la demande de brevet US-A-2005142708, il a été proposé d'utiliser une couche métallique disposée sous la couche intermédiaire en silice, pour réfléchir la lumière du faisceau laser, afin d'obtenir des grains plus homogènes dans l'épaisseur de la couche à cristalliser. Cependant, à ce jour, la cristallisation par voie liquide, en utilisant un laser, ne produit que des polycristaux, dont la taille de grain est au mieux de l'ordre du micromètre, pour des couches ayant une épaisseur inférieure à 100nm.

Une autre technique consiste à cristalliser le matériau en phase solide, c'est-à-dire sans passer par l'état liquide. La cristallisation en phase solide est, généralement, réalisée par recuit thermique conventionnel, également appelé SPC. Ainsi, l'empilement formé d'une couche amorphe déposée sur un substrat est soumis à un recuit, réalisé pendant une durée variant de plusieurs minutes à quelques heures, suivant la température et le type de matériau à cristalliser. Le matériau à cristalliser et le substrat sont, de plus, portés à la même température, qui est traditionnellement maintenue en dessous de la température de transition vitreuse ou de fusion du substrat.

La cristallisation en phase solide peut, également, être favorisée par un dépôt de matériaux facilitant la germination des cristallites. Une telle technique, appelée recuit assisté par un métal ou « MIC », est décrite dans la demande de brevet US-A-5994164 pour ajuster de manière contrôlée la taille de grain d'une couche mince en silicium amorphe, cristallisée en phase solide. Ainsi, un élément catalyseur, tel que du palladium ou du nickel, est disposé sur la couche à cristalliser, pour contrôler la taille de grain de ladite couche, avant qu'un traitement thermique dans un four conventionnel ne soit réalisé, par exemple à environ 600°C pendant 10 minutes ou moins.

La demande de brevet US-A-5994164 mentionne également une solution alternative pour contrôler la taille de grain. Cette solution alternative consiste à réaliser un recuit thermique rapide, également appelé RTA. Celui-ci permet de diminuer considérablement la durée de cristallisation des couches sur substrat. La technique RTA aboutit, cependant à des grains beaucoup moins défectueux mais plus petits qu'un recuit thermique conventionnel, du fait du grand nombre de germes créés.

Cependant, le substrat en verre utilisé dans la demande de brevet US-A-5994164 selon la technique MIC ou selon la technique RTA se déforme légèrement. La demande de brevet US-A-5994164 préconise, alors, une autre solution consistant à déposer, entre le substrat et la couche à cristalliser, une couche intermédiaire ayant une température de transition vitreuse plus faible que la température de cristallisation en phase solide de la couche à cristalliser, pour permettre la relaxation de la contrainte induite par la cristallisation de ladite couche et éviter la déformation du substrat.

Il existe également des procédés de dépôt de matériaux sur un substrat, par pulvérisation réactive par magnétron ou par dépôt chimique en phase vapeur assisté par plasma (PECVD), qui permettent une cristallisation partielle du matériau sur le substrat. Cependant, avec ces techniques de dépôt, la dimension des grains obtenus est inférieure au micromètre, ce qui ne procure pas toujours au matériau les propriétés thermiques, optiques et électroniques optimales pour les applications voulues. A titre d'exemple, J.E. Gerbi et al. étudient, dans l'article « Deposition of microcrystalline silicon : Direct evidence for hydrogen-induced surface mobility of Si adspecies » (Journal of Applied Physics, Janvier 2001, Vol 89, N°2, p1463-1469), le dépôt par pulvérisation réactive par magnétron de films en silicium microcristallin hydrogéné, sur un film en chrome thermiquement évaporé sur un substrat en verre non chauffé. La formation de films en silicium microcristallin est réalisée pour des pressions partielles en hydrogène élevées et pour une température de substrat comprise entre 150°C et 300°C.

US 7 192 818 montre un procédé de cristallisation comportant les étapes successives de dépôt d'une couche d'oxynitrure de silicium pour absorber la chaleur, puis d'une couche de silicium amorphe et enfin d'une couche d'aluminium sur un substrat en verre, la couche de silicium étant fondue par une irradiation laser pour être cristallisée. De même US 2006/267073 décrit un procédé de cristallisation avec dépôt de plusieurs couches d'isolants sur un substrat de verre, d'une couche de silicium amorphe et enfin d'une couche métallique de nickel, la couche de silicium étant fondue pour être cristallisée par une irradiation de laser excimer pulsée.

### Objet de l'invention

L'invention a pour but un procédé de cristallisation remédiant aux inconvénients des procédés selon l'art antérieur. L'invention a, en particulier, pour but d'obtenir un matériau cristallisé de faible épaisseur, par exemple de l'ordre de la centaine de nanomètres, et de très grande surface, avec des propriétés homogènes sur toute ladite surface.

Selon l'invention, ce but est atteint par les revendications annexées.

Plus particulièrement, ce but est atteint par un procédé de cristallisation en phase solide comportant les étapes successives suivantes :
a) dépôt d'au moins d'une couche mince en matériau amorphe ou polycristallin, sur au moins une zone de la surface d'une partie supérieure d'un substrat,
b) dépôt d'au moins une couche métallique, d'une épaisseur comprise entre 1nm et 20nm, avantageusement entre 5nm et 10nm, sur une zone de ladite couche mince, la partie supérieure du substrat étant constituée, après l'étape b), par un matériau amorphe apte à passer dans un état liquide ou de liquide surfondu
c) et traitement thermique pour permettre la croissance cristalline du matériau de la couche mince, en provoquant simultanément :
   - une montée de la température de la partie supérieure du substrat à une vitesse supérieure à 100K par seconde, jusqu'à ce que le matériau de la partie supérieure du substrat passe à l'état liquide ou à l'état de liquide surfondu,
   - et un transfert thermique depuis l'interface entre la partie supérieure du substrat et la couche mince vers l'interface entre la couche mince et la couche métallique.

Et en ce que l'étape c) est réalisée par application d'un faisceau laser continu ou pulsé, présentant une gamme de longueurs d'onde d'émission correspondant à la gamme de longueurs d'onde d'absorption de la partie supérieure (2) du substrat (1) et à la gamme de longueurs d'onde de transparence du matériau amorphe ou polycristallin de la couche mince (3) à cristalliser.

Selon un développement de l'invention l'étape c) est réalisée par application d'un faisceau laser continu ou pulsé, présentant une gamme de longueurs d'onde d'émission correspondant à la gamme de longueurs d'onde d'absorption de la partie supérieure du substrat et à la gamme de longueurs d'onde de transparence du matériau amorphe ou polycristallin de la couche mince à cristalliser.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
- Les figures 1 à 7 représentent schématiquement, en coupe, différentes étapes d'un premier mode de réalisation d'un procédé selon l'invention.
- La figure 8 représente le cycle en température appliqué à la partie supérieure du substrat en fonction du temps, pendant ledit premier mode de réalisation.
- Les figures 9 à 12 représentent schématiquement, en coupe, une variante de réalisation dudit premier mode de réalisation.
- Les figures 13 à 16 représentent, schématiquement, en coupe, différentes étapes d'un troisième mode de réalisation d'un procédé selon l'invention.
- Les figures 17 à 20 représentent, schématiquement, en coupe, différentes étapes d'un quatrième mode de réalisation d'un procédé selon l'invention.

### Description de modes particuliers de réalisation

Un procédé de cristallisation comporte une étape de dépôt d'au moins une couche mince, en un matériau amorphe ou polycristallin destiné à être cristallisé par exemple sous forme monocristalline, sur au moins une zone de la surface d'une partie supérieure d'un substrat. L'étape de dépôt de la couche mince est suivie d'une étape de dépôt d'au moins une couche métallique, sur une zone de ladite couche mince en matériau amorphe ou polycristallin. La couche métallique a une épaisseur comprise entre 1nm et 20nm, avantageusement entre 5nm et 10nm. Puis, une étape de traitement thermique est réalisée. Dans certaines conditions, une atmosphère réductrice, inerte ou oxydante peut être prévue lors du traitement thermique.

Par ailleurs, la partie supérieure du substrat est constituée par un matériau distinct du matériau à cristalliser. Le matériau de la partie supérieure du substrat est, de plus, amorphe avant le traitement thermique et il est apte à passer à l'état de liquide ou à l'état de liquide surfondu.

La partie supérieure du substrat est, par exemple, constituée avant l'étape de traitement thermique, par un matériau amorphe tel que :
- un verre, par exemple les verres à base d'oxyde (oxyde de silicium (SiO₂), borosilicate (B₂O₃,SiO₂),) et les verres à base de chalcogénure (tel que As₂Se₃) ou des céramiques comme l'alumine (Al₂O₃)...
- ou un polymère non cristallin tel que le polycarbonate.

Dans ce cas, ledit matériau amorphe peut être soumis à un phénomène de transition vitreuse.

En effet, dans le cas d'un verre, l'étude de la variation d'une grandeur thermodynamique, telle que la chaleur spécifique volumique, permet de constater que, lors du refroidissement de la phase liquide stable, si la viscosité est trop importante ou si le refroidissement est très rapide, la cristallisation n'a pas le temps de se produire et un liquide surfondu est obtenu. La zone de température dans laquelle est obtenu le liquide surfondu correspond à la zone de transition vitreuse. De plus, en poursuivant le refroidissement, la viscosité du liquide augmente fortement et le liquide surfondu devient quasiment solide. Or, lorsque la viscosité atteint 10¹³ poises, la rigidité empêche les mouvements microscopiques locaux et un changement de pente de la grandeur étudiée est observé. La température à laquelle se produit ce changement correspond à la température de transition vitreuse du matériau (Tg). Ainsi, pour une température inférieure à la température de transition vitreuse, le matériau est dit solide avec le désordre structural d'un liquide, tandis qu'au-dessus de la température de fusion, le matériau est dit à l'état liquide. Par zone de transition vitreuse, on entend donc une plage de température, délimitée par la température de fusion et par la température de transition vitreuse dudit matériau. Cette zone de transition vitreuse correspond au passage de l'état solide à l'état liquide du matériau. Dans cette zone de température dite zone de transition ou zone de transition vitreuse, le matériau est considéré à l'état de liquide surfondu.

Plutôt que d'être en verre ou en polymère non cristallin, la partie supérieure du substrat peut également être constituée par un métal (par exemple Fe, Cu, Ti...) ou un alliage métallique (par exemple de l'acier inoxydable), amorphe avant l'étape de traitement thermique. Dans ce cas, la zone de transition correspond à la température de fusion du matériau constituant la partie supérieure du substrat.

Par ailleurs, le matériau constituant la partie supérieure du substrat peut être le même matériau que celui constituant la couche mince à cristalliser, les deux matériaux présentant, alors, préférentiellement, des états de structure différents. Par exemple, le matériau constituant la partie supérieure du substrat peut être sous forme amorphe, tandis que celui constituant la couche mince à cristalliser peut être sous forme polycristalline. Cependant, de manière avantageuse, le matériau de la partie supérieure du substrat est distinct du matériau amorphe ou polycristallin à cristalliser.

Ainsi, dans le procédé de cristallisation selon l'invention, l'étape de traitement thermique est destinée à provoquer une montée très rapide de la température de la partie supérieure du substrat, avantageusement sans chauffer directement la couche mince à cristalliser. La montée en température, également appelée rampe thermique, est réalisée à une vitesse supérieure à 100K par seconde et elle est réalisée jusqu'à ce que la partie supérieure du substrat atteigne la zone de transition. Ainsi, la montée en température est réalisée jusqu'à ce que la partie supérieure du substrat passe dans un état de liquide ou dans un état de liquide surfondu.

Le traitement thermique est, avantageusement, réalisé par un faisceau laser polarisé, dont l'énergie est absorbée par la partie supérieure du substrat. Par contre, contrairement à un procédé de cristallisation par voie liquide, dans le cadre de l'invention, le faisceau laser ne chauffe pas directement la couche mince à cristalliser, mais la partie supérieure du substrat. Ainsi, la couche mince à cristalliser ne passe pas dans un état liquide, mais reste dans un état solide. Ainsi, bien qu'utilisant avantageusement un faisceau laser, le procédé de cristallisation est un procédé de cristallisation par voie solide.

L'apport de chaleur du faisceau laser est, en effet, suffisant pour que la partie supérieure du substrat passe de l'état solide à l'état de liquide ou de liquide surfondu. Par contre, la couche mince à cristalliser reste, avantageusement, « froide », afin que le flux thermique soit initialement le plus intense possible, entre la partie supérieure du substrat et la couche mince à cristalliser. Autrement dit, la couche mince à cristalliser n'absorbe pratiquement pas l'énergie émise par le faisceau laser.

Pour obtenir une montée rapide de la température de la partie supérieure du substrat, sans chauffer directement la couche mince à cristalliser, le faisceau laser utilisé lors de l'étape de traitement thermique présente, avantageusement, une gamme de longueurs d'onde d'émission correspondant :
- à la gamme de longueurs d'onde d'absorption de la partie supérieure du substrat
- et à la gamme de longueurs d'onde de transparence du matériau amorphe ou polycristallin à cristalliser.

Par ailleurs, le faisceau laser peut également être continu ou pulsé et il peut être un laser CO₂ ou YAG.

De plus, l'étape de traitement thermique doit provoquer, simultanément le passage de la partie supérieure du substrat en phase liquide ou liquide surfondu, et un transfert thermique à travers la couche mince à cristalliser, depuis l'interface de ladite couche avec le substrat vers l'interface de ladite couche et la couche métallique.

Or, pour obtenir un flux thermique le plus intense possible, le coefficient d'absorption de la partie supérieure du substrat est, avantageusement, trois fois supérieur à celui de la couche mince à cristalliser, dans la gamme de longueurs d'onde d'émission du faisceau laser.

En effet, il a été trouvé, de manière surprenante, que le transfert thermique de la chaleur depuis la partie supérieure du substrat à travers la couche mince à cristalliser provoque une mise en contrainte de la couche mince à cristalliser. Or, cette mise en contrainte est d'autant plus intense que la rampe thermique est rapide et que la différence de température instantanée entre le substrat et la couche est importante. De plus, cette redistribution de la contrainte initiale favorise thermodynamiquement la cristallisation, puisqu'il y a alors réduction du volume molaire de la couche mince à cristalliser, qui tend vers celui de la phase cristalline.

Le flux thermique doit être maintenu, afin que la croissance cristalline « à l'état solide» puisse se poursuivre. Pour cela, la chaleur issue de la partie supérieure du substrat ainsi que l'enthalpie de cristallisation doivent pouvoir être évacuées en surface de la couche mince en train de cristalliser. Cette évacuation est réalisée de manière radiative par la couche métallique.

Lors de la redescente en température, la zone surfondue du substrat s'adapte à la densification de la couche cristallisée, avant de passer à l'état solide.

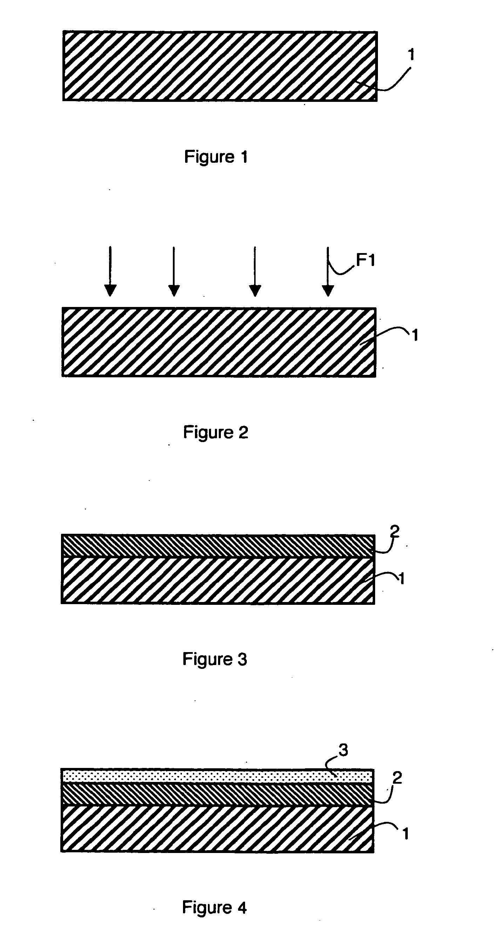

Selon un premier mode de réalisation, représenté sur les figures 1 à 7, la cristallisation d'un matériau est obtenue à partir d'un substrat 1 formé, par exemple, par un matériau cristallin qui, rendu amorphe, présente un phénomène de transition vitreuse. Le substrat 1 est, en particulier, traité pour former une partie supérieure 2 amorphe dans le substrat 1. Les flèches F1 représentent, sur la figure 2, l'étape de traitement permettant de rendre la partie supérieure 2 du substrat 1 amorphe. À titre d'exemple, la partie supérieure 2 du substrat 1 peut être rendue amorphe par polissage ou par implantation ionique.

Comme illustré sur la figure 4, une couche mince 3 constituée par un matériau à cristalliser est, ensuite, déposée sur la surface libre de la partie supérieure 2 du substrat 1. La surface libre de la partie supérieure du substrat peut être préalablement nettoyée, avant le dépôt de la couche mince 3. De plus, sur la figure 4, la couche mince 3 est déposée sur la totalité de la surface libre de la partie supérieure 2 du substrat 1.

Le matériau à cristalliser est, plus particulièrement, déposé sous une forme amorphe ou polycristalline. Il peut être de tout type dès lors qu'il est apte à cristalliser en phase solide. À titre d'exemple, il est un matériau semi-conducteur tel que le silicium, le germanium, l'arséniure de gallium (AsGa), l'arséniure de gallium et d'indium (InGaAs), l'antimoniure d'indium (InSb). Il peut également être un matériau isolant tel qu'un oxyde, par exemple l'oxyde de silicium (SiO₂), l'oxyde de bore (B₂O₃), l'oxyde de titane (TiO₂), l'oxyde de tantale (Ta₂O₅) ou bien il peut être du séléniure d'arsenic (As₂Se₃).

De plus, le dépôt de la couche mince 3 peut être de tout type connu. Par exemple, la couche mince 3 peut être déposée par évaporation, par pulvérisation éventuellement assistée par canon à ions ou par magnétron.

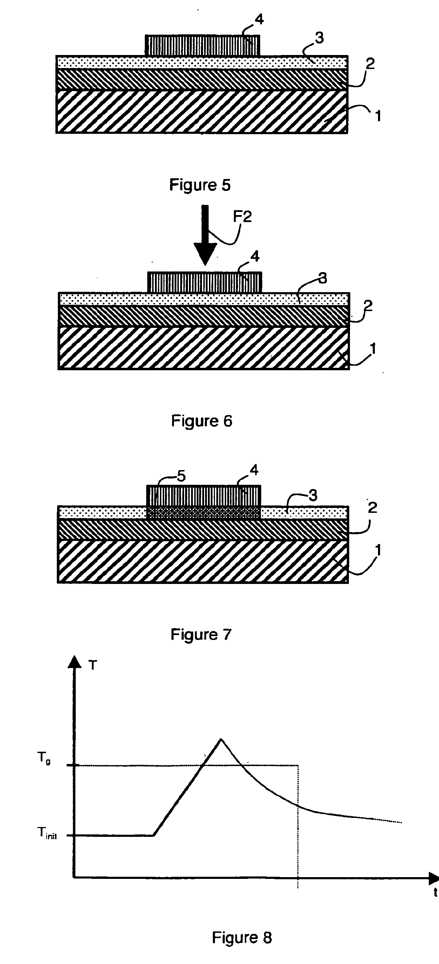

Puis, comme représenté sur la figure 5, une couche métallique 4 est déposée sur une zone de la surface libre de la couche mince 3. L'épaisseur de ladite couche métallique 4 est comprise entre 1nm et 20nm, avantageusement entre 5nm et 10nm. Lorsque l'épaisseur de la couche métallique est très faible, par exemple de l'ordre de 1nm, il n'est pas possible d'avoir une couche métallique autrement que sous la forme d'une pluralité d'agrégats.

La couche métallique 4 est, en particulier, constituée par un métal tel qu'un métal utilisé en catalyse (Ni, Pd, Pt), mais pas seulement. Il peut également être choisi parmi Cu, Ag, Cr, Au, Fe.... De plus, la couche métallique 4 peut être constituée par un métal pur, un alliage métallique ou un mélange de métaux (Ni+Cr, Ni+Au...). Dans un mode de réalisation privilégié, la couche métallique 4 n'est pas continue, elle est constituée par des agrégats du métal. Dans tous les modes de réalisation, la couche métallique 4 peut être disposée sur toute la surface du substrat ou seulement sur des zones où la cristallisation est recherchée. L'épaisseur de la couche métallique constituée par des agrégats à une épaisseur qui est équivalente en masse à celle d'une couche continue comprise entre 1 et 20nm, avantageusement entre 3 et 10nm.

Par ailleurs, contrairement à l'enseignement du document US-A-5994164, la couche métallique 4 n'est pas, dans le cadre de l'invention, destinée à jouer le rôle de catalyseur pour ajuster de manière contrôlée la taille des grains. C'est l'association de ladite couche métallique, préférentiellement sous forme d'agrégats, avec un traitement thermique particulier permettant à la partie supérieure du substrat de passer dans un état liquide ou de liquide surfondu, avantageusement sans chauffer directement la couche mince à cristalliser qui permet, selon l'invention, d'obtenir la cristallisation en phase solide. Plus particulièrement, la couche métallique 4 sert de radiateur pour évacuer la chaleur se trouvant dans la couche mince à cristalliser, c'est-à-dire qu'elle sert à évacuer la chaleur, issue de la couche mince à cristalliser, de façon radiative. Sans cette couche métallique, la couche à cristalliser passe à l'état liquide et le procédé n'est plus un procédé en « phase solide ». Dans le cas privilégié où la couche métallique est constituée par des agrégats, une émission radiative de la chaleur est réalisée par les agrégats métalliques en interaction avec la couche à cristalliser.

Puis, comme représenté sur les figures 6 et 7, une fois la couche mince 3 et la couche métallique 4 déposées, l'ensemble, constitué par le substrat 1, la couche mince 3 et la couche métallique 4, subit un traitement thermique. Le traitement thermique est destiné à apporter de la chaleur à la partie supérieure 2 du substrat 1 et à provoquer une montée rapide de la température dans la partie supérieure 2 du substrat 1 et plus généralement dans le substrat 1. La température de la partie supérieure 2 du substrat 1 monte, ainsi, au moins jusqu'à la zone de transition vitreuse, de sorte que ladite partie supérieure 2 passe au moins à l'état de liquide surfondu. La montée en température de la partie supérieure 2 du substrat doit être rapide, avec une vitesse supérieure à 100K/s.

Une telle montée en température peut être obtenue en faisant interagir, par exemple, un faisceau laser continu ou pulsé sur la partie supérieure 2 du substrat 1, à travers la couche métallique 4 et la couche mince 3. Dans ce cas, la gamme de longueurs d'onde d'émission du faisceau laser correspond à la gamme de longueurs d'onde d'absorption de la partie supérieure 2 du substrat 1. Ainsi, l'émission du faisceau laser est en partie ou totalement absorbée par la partie supérieure 2 du substrat 1. Par contre, la gamme de longueurs d'onde d'émission du faisceau laser correspond également à la gamme de longueurs d'onde de transparence de la couche mince 3. La couche mince 3 n'absorbant pas ou peu les longueurs d'onde du faisceau laser, elle n'est pas chauffée directement. Sur la figure 5, le faisceau laser est représenté par la flèche F2 et il est appliqué de manière à traverser la couche métallique 4 et la couche mince 3 avant d'atteindre la partie supérieure 2 du substrat.

À titre d'exemple, pour une partie supérieure 2 en silice et une couche mince 3 à cristalliser en germanium, le faisceau laser peut être un laser CO₂ émettant à 10,6µm. Selon un autre exemple, pour une partie supérieure 2 métallique et une couche mince 3 à cristalliser en silicium, le faisceau laser peut être un laser CO₂ ou un laser YAG, émettant à 1,064 µm. À cette longueur d'onde, le silicium amorphe absorbe peu (quelques centaines de cm⁻¹) par rapport au métal.

Ainsi, pendant le traitement thermique, la partie supérieure 2 du substrat passe de l'état solide à un état de liquide surfondu et permet la cristallisation d'une zone 5 de la couche mince 3, par transfert thermique. La zone 5 correspond à la zone de la couche mince 3, disposée sous la couche métallique 4, tandis que le reste de la couche mince 3, non recouvert par la couche mince métallique, n'est pas cristallisé (figure 7). De plus, si la couche métallique 4 recouvre la totalité de la couche mince 3 à cristalliser, celle-ci peut être entièrement cristallisée.

À titre d'exemple, la figure 8 représente le cycle en température appliqué à la partie supérieure 2 du substrat 1 en fonction du temps, dans le mode de réalisation représenté sur les figures 1 à 7. La température de la partie supérieure 2 du substrat 1 reste, par exemple, constante pendant le dépôt de la couche mince 3, puis elle augmente rapidement pendant l'étape de traitement thermique. L'augmentation de la température de la partie supérieure 2 du substrat 1 est, par exemple, linéaire et elle va au-delà de la température de transition vitreuse du matériau de la partie supérieure 2 du substrat 1.

La partie supérieure 2 du substrat 1 peut être en tout type de matériau solide, amorphe ou apte à le devenir par traitement, dès lors que le matériau est apte à passer à l'état liquide ou de liquide surfondu. Ainsi, la partie supérieure 2 du substrat 1 ou même la totalité du substrat 1 peut être amorphe avant le procédé de cristallisation. Le substrat ou au moins une partie supérieure du substrat peut, par exemple, être constitué par un verre, tel qu'un oxyde amorphe, un élément ou un matériau semi-conducteur amorphe ou par un polymère non cristallin. Comme l'illustre le mode de réalisation représenté par les figures 1 à 7, la partie supérieure du substrat ou même la totalité du substrat peut également être, en début de procédé, sous une forme cristalline. Dans ce cas, elle peut subir, avant le traitement thermique, un traitement permettant d'obtenir au moins une partie supérieure sous forme amorphe. La partie supérieure du substrat ou la totalité du substrat peut, ainsi, être rendue amorphe avant le dépôt de la couche mince à cristalliser 3, avant ou après le dépôt de la couche métallique 4.

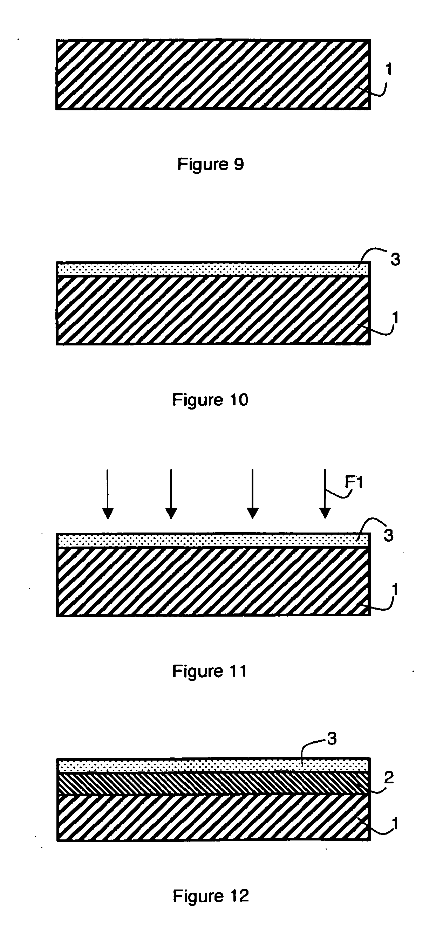

Ainsi, comme illustré dans une variante de réalisation représentée sur les figures 9 à 12, le substrat 1 peut rester cristallin pendant le dépôt de la couche mince 3. Un traitement, illustré par les flèches F1 sur la figure 11, peut, alors, être réalisé après le dépôt de la couche mince 3 et avant le traitement thermique. Ce traitement permet d'obtenir une partie supérieure 2 amorphe. Enfin, même si le substrat 1 ou tout du moins une partie supérieure 2 du substrat est sous forme amorphe avant le dépôt de la couche mince 3, le substrat ou ladite partie supérieure 2 du substrat 1 peut subir un traitement apte à renforcer l'état de contrainte en surface, avant le traitement thermique. Un tel traitement peut être réalisé avant le dépôt ou après le dépôt de la couche mince 3. À titre d'exemple, le traitement peut être :
- un traitement mécanique tel qu'un polissage, un sablage,
- un traitement thermique tel qu'une fusion suivie d'une trempe,
- un traitement physico-chimique tel qu'un dépôt en phase vapeur ou une implantation ionique.

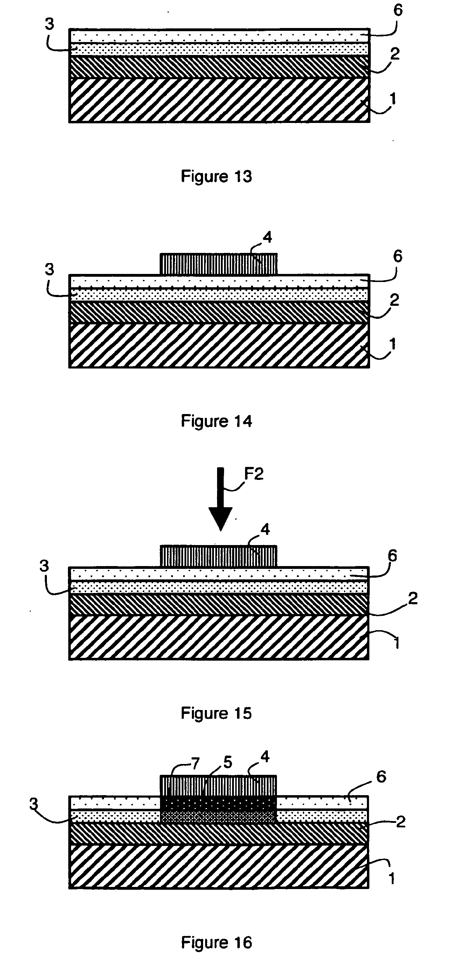

Dans un autre mode de réalisation illustré sur les figures 13 à 16, plusieurs couche minces, respectivement constituées par des matériaux distincts à cristalliser, par exemple sous forme monocristalline sont successivement déposées sur la surface de la partie supérieure 2 du substrat 1. À titre d'exemple, sur la figure 13, une couche mince supplémentaire 6 est déposée sur la couche mince 3 à cristalliser, de manière à obtenir deux couches minces superposées. Une couche métallique 4 est, ensuite, déposée sur une zone de la couche mince supplémentaire 6. L'ensemble, formé par le substrat 1, les deux couches minces superposées 6, 3 et la couche métallique 4, subit ensuite un traitement thermique (flèche F2 sur la figure 15) destiné à cristalliser non seulement le matériau de la couche mince 3 mais également celui de la couche mince supplémentaire 6. Une fois le traitement thermique terminé, deux zones 5 et 7, superposées et chacune cristallisées, par exemple sous forme monocristalline sont, alors obtenues respectivement dans les couches minces 3 et 6, sous la couche métallique 4.

Selon un développement privilégié de l'invention, il est avantageux de prévoir le dépôt d'un oxyde additionnel, par exemple un oxyde de silicium, de quelques nanomètres d'épaisseur, par exemple 5 nm. Cette couche d'oxyde additionnel (non représentée) est disposée sous la couche métallique 4. La couche d'oxyde additionnel permet de favoriser le phénomène de cristallisation solide de la couche à cristalliser amorphe située juste au-dessous.

In est, ainsi, possible de cristalliser, par une étape unique de traitement thermique, une pluralité de couches minces superposées en matériaux distincts et cristallins. Un tel mode de réalisation est également appelé cristallisation en mode série et il peut notamment être utilisé pour réaliser des hétérostructures. La cristallisation peut même inclure la couche métallique. De plus, la cristallisation a lieu sous la couche métallique 4 et à ses abords. De plus, si la couche métallique 4 recouvre la totalité de la surface libre de la couche mince supplémentaire 6, les couches 3 et 6 peuvent être totalement cristallisées.

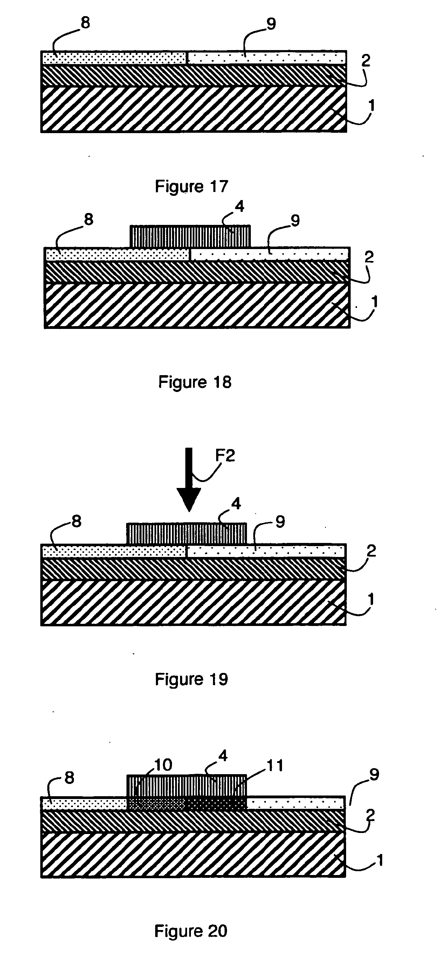

Dans une variante représentée sur les figures 17 à 20, une pluralité de couches minces peut être déposée sur une pluralité de zones de la surface de la partie supérieure 2 du substrat 1, avant le traitement thermique. Ainsi, sur la figure 17, la surface de la partie supérieure 2 est recouverte par deux couches minces 8 et 9, adjacentes et respectivement constituées par des matériaux distincts à cristalliser, par exemple sous forme monocristalline. Une couche métallique 4, d'une épaisseur comprise entre 1nm et 20nm est, ensuite, déposée sur l'empilement, de manière à avantageusement recouvrir une partie de la couche mince 8 et une partie de la couche mince 9 (figure 18). L'ensemble formé par le substrat, les deux couches minces adjacentes 8 et 9 et la couche métallique 4 subit ensuite un traitement thermique (flèche F2 sur la figure 19) destiné à cristalliser en même temps les matériaux respectifs des couches minces 8 et 9 disposés sous la couche métallique 4. Une fois le traitement thermique terminé, on obtient alors, dans les couches minces 8 et 9, des zones 10 et 11 adjacentes, cristallisées et correspondant aux zones respectives des couches minces 8 et 9 disposées sous la couche métallique 4.

Il est, alors, possible de cristalliser, en une seule étape de traitement thermique, une pluralité de couches minces adjacentes. Plus particulièrement, les deux couches minces 8 et 9 peuvent être successivement déposées sur la surface de la partie supérieure 2 du substrat. Ainsi, la couche mince 8 peut être préalablement déposée sur une zone de la surface de la partie supérieure 2 du substrat, à travers un masque cachant la zone destinée à être recouverte par la deuxième couche mince 8. Puis, la deuxième couche mince est déposée sur la zone libre du substrat, à travers un masque cachant la couche mince 8 déjà déposée. Une telle variante est, également appelée cristallisation en mode parallèle et elle est, particulièrement, adaptée pour associer les fonctionnalités de plusieurs matériaux sur un même substrat.

Un procédé de cristallisation selon l'invention permet donc de cristalliser un matériau d'épaisseur nanométrique. Contrairement au procédé de Czochralski, il est, alors, possible d'obtenir des couches minces cristallines de très faible épaisseur, par exemple d'une épaisseur de l'ordre d'une centaine de nanomètres, sans nécessiter d'étapes supplémentaires de conditionnement.

De plus, un tel procédé permet d'obtenir des couches minces cristallines de très grande surface et avantageusement monocristallines, avec des propriétés homogènes sur toute ladite surface.

Un tel procédé est relativement peu coûteux, car il ne nécessite pas de creuset et il présente un budget thermique relativement faible puisque l'apport de chaleur nécessaire à la cristallisation n'a pas besoin d'atteindre la température de fusion du matériau à cristalliser.

Enfin, la couche mince cristallisée peut être dans une phase cristalline différente, avec des propriétés physiques différentes de celles synthétisées par les procédés de cristallisation existants. Un tel procédé de réalisation peut être utilisé dans le domaine des procédés nanotechnologiques, mais également dans le domaine énergétique et plus particulièrement dans le domaine des cellules photovoltaïques.

A titre d'exemple, un dispositif de mise en oeuvre du procédé de cristallisation peut comporter :
- une source laser CO₂ émettant un faisceau laser continu
- un dispositif de contrôle et de stabilité de la puissance du faisceau laser
- une lentille de focalisation destinée à focaliser le faisceau laser sur le substrat muni d'une couche mince à cristalliser et d'une couche métallique, préalablement déposées sur ledit substrat
- et un dispositif de déplacement dudit substrat ou du faisceau laser, de manière à pouvoir traiter thermiquement l'ensemble de la surface du substrat.

Le substrat est, par exemple, du verre Corning pour écrans plats, de température vitreuse de l'ordre de 550°C et d'une épaisseur de l'ordre de 1 mm. La couche mince à cristalliser est, par exemple, en silicium amorphe déposé par évaporation sous vide, l'épaisseur de la couche mince est égale à 500nm et la température du substrat lors de l'évaporation est égale à 400°C. Une couche de silice, d'une épaisseur de 5nm, est déposée par évaporation sous vide sur la couche de silicium amorphe. La couche métallique, formée par des agrégats d'or, est ensuite déposée sur la couche d'oxyde de silicium. La couche métallique a une épaisseur équivalent égale à 5nm.. Tous ces dépôts peuvent être réalisés à la même température de substrat dans un même équipement de dépôt sous vide.

Le faisceau laser CO₂ continu permet de réaliser un traitement thermique de la couche supérieure du substrat. La longueur d'onde d'émission dudit laser est de l'ordre de 10,59 µm, ce qui correspond à la raie d'émission du laser la plus puissante. Cette longueur d'onde d'excitation est adaptée à la gamme d'absorption de la couche supérieure du substrat, ce qui permet une montée en température de ladite couche supérieure. En effet, dans le verre, toutes les raies d'émission du faisceau laser CO₂, (9,2 - 10,8 µm) peuvent être utilisées. La stabilité en puissance de la source d'excitation est standard, typiquement de l'ordre de ±3%, sur la durée du traitement thermique. De plus, le mode d'émission laser peut être quelconque (gaussien, plat, annulaire ...), mais il doit être stable. Il est, avantageusement, plat. Enfin, la puissance nécessaire pour effectuer le traitement thermique est une puissance linéique qui dépend des dimensions caractéristiques du faisceau laser et des propriétés physiques de la couche supérieure amorphe du substrat (absorption, conductivité thermique ...), ainsi que de la vitesse de balayage dudit faisceau. Pour un faisceau laser gaussien de diamètre à 1/e de 300 µm, la puissance laser incidente pour réussir la cristallisation est typiquement de 2 Watts, à la vitesse de 1 cm/s, en interaction avec le dispositif de mise en oeuvre décrit ci-dessus.

Ainsi, le rayonnement du faisceau laser CO₂ est incident en face avant de l'empilement formé par la couche d'agrégats métalliques, la couche très mince d'oxyde, la couche mince à cristalliser et le substrat. Il traverse le métal et la couche mince à cristalliser, avant d'être absorbé dans le substrat et provoquer une montée rapide de la température dudit substrat, avec passage dans la zone de transition vitreuse, ce qui provoque la cristallisation de la couche mince en silicium.

Le dispositif de contrôle et de stabilité de la puissance du laser comprend, de préférence, plusieurs éléments : un variateur de puissance laser qui peut être constitué d'une lame demi onde suivie d'un polariseur. Un tel dispositif permet d'ajuster la puissance d'excitation à une consigne et donc de faire varier la puissance appliquée au substrat à traiter thermiquement. Ce dispositif peut être complété par un obturateur et par un dispositif de mesure de la puissance laser destiné à vérifier que la consigne de puissance est bien atteinte. Il peut même inclure un dispositif de stabilisation en temps réel de la puissance du laser de recuit. L'obturateur pourrait être remplacé par un dispositif de commutation « éteint-allumé » de la source laser elle-même.

La lentille de focalisation est, par exemple, en ZnSe et elle peut être traitée pour être anti-reflet à la longueur d'onde d'émission du faisceau laser. Sa distance focale peut être adaptée à la tache focale souhaitée sur la couche mince à cristalliser. De plus, les dimensions de la tache focale, à la surface de l'empilement, peuvent être déterminées par une méthode dite du couteau. La lentille peut également être cylindrique, afin de produire un pinceau lumineux plus étendu dans une direction perpendiculaire au sens de balayage. Ceci permet de couvrir une plus grande surface de substrat par ligne de passage.

L'invention n'est pas limitée aux modes de réalisation décrits ci-dessus. La surface de la partie supérieure 2 du substrat 1 n'est pas nécessairement plane. Elle peut, par exemple, être sphérique, concave ou convexe, ou bien elle peut comporter des zones en creux et/ou des zones en relief. De plus, ladite surface peut être structurée lors de son passage à l'état liquide ou de liquide surfondu. Cette structuration peut être induite par différents procédés mécaniques, acoustiques, lasers, ...

Un tel procédé de cristallisation peut être appliqué à des dispositifs qui nécessitent des couches cristallines, tels que des dispositifs électroniques (diode, transistor, ...), des dispositifs optiques (miroir, optique sphérique,...), des dispositifs photoniques (guide d'onde,...),...

Le procédé de cristallisation est, en effet, intrinsèquement favorable à la cristallisation des couches ayant une épaisseur allant de l'ordre du nanomètre jusqu'à plusieurs centaines de nanomètres. Cependant, pour cristalliser une couche plus épaisse ou obtenir de nouvelles phases cristallines, il peut être avantageux de refroidir initialement l'empilement formé par le substrat, la couche mince à cristalliser et la couche métallique, afin de faciliter le transfert thermique du substrat à travers la couche amorphe que l'on désire cristalliser jusqu'à la couche métallique de surface.

## Revendications

1. Procédé de cristallisation en phase solide, **caractérisé en ce qu'**il comporte les étapes successives suivantes :
a) dépôt d'au moins d'une couche mince (3) en matériau amorphe ou polycristallin, sur au moins une zone de la surface d'une partie supérieure (2) d'un substrat (1),
b) dépôt d'au moins une couche métallique (4), d'une épaisseur comprise entre 1 nm et 20nm, avantageusement entre 5nm et 10nm, sur une zone de ladite couche mince (3), la partie supérieure (2) du substrat (1) étant constituée, après l'étape b), par un matériau amorphe apte à passer dans un état de liquide ou de liquide surfondu,
c) et traitement thermique pour permettre la croissance cristalline du matériau de la couche mince (3), en provoquant simultanément :
- une montée de la température de la partie supérieure (2) du substrat (1) à une vitesse supérieure à 100K par seconde, jusqu'à ce que le matériau de la partie supérieure du substrat passe à l'état de liquide ou à l'état de liquide surfondu
- et un transfert thermique depuis l'interface entre la partie supérieure (2) du substrat (1) et la couche mince (3) vers l'interface entre la couche mince (3) et la couche métallique (4).
Et **en ce que** l'étape c) est réalisée par application d'un faisceau laser continu ou pulsé, présentant une gamme de longueurs d'onde d'émission correspondant à la gamme de longueurs d'onde d'absorption de la partie supérieure (2) du substrat (1) et à la gamme de longueurs d'onde de transparence du matériau amorphe ou polycristallin de la couche mince (3) à cristalliser.

2. Procédé selon la revendication 1, **caractérisé en ce que** le coefficient d'absorption de la partie supérieure du substrat est, trois fois supérieur à celui de la couche mince à cristalliser, dans la gamme de longueurs d'onde d'émission du faisceau laser.

3. Procédé selon l'une des revendications 1 et 2, **caractérisé en ce que** le faisceau laser est obtenu à partir d'une source laser CO₂ ou YAG.

4. Procédé selon l'une quelconque des revendications 1 à 3, **caractérisé en ce qu'**une étape de refroidissement de l'empilement comportant le substrat, la couche mince (3) et la couche métallique (4) est réalisée entre les étapes b) et c).

5. Procédé selon l'une quelconque des revendications 1 à 4, **caractérisé en ce que** la partie supérieure (2) du substrat (1) est amorphe avant l'étape a).

6. Procédé selon l'une quelconque des revendications 1 à 4, **caractérisé en ce que** la partie supérieure (2) du substrat (1) étant cristalline avant l'étape a), elle est rendue amorphe après l'une des deux étapes a) et b).

7. Procédé selon l'une quelconque des revendications 1 à 6, **caractérisé en ce que** la partie supérieure (2) du substrat (1) est constituée par un matériau choisi parmi les verres, les céramiques, les polymères non cristallins, les métaux et les alliages métalliques.

8. Procédé selon l'une quelconque des revendications 1 à 7, **caractérisé en ce que** le substrat (1) est entièrement en matériau amorphe avant l'étape c).

9. Procédé selon l'une quelconque des revendications 1 à 8, **caractérisé en ce que** l'étape a) comporte le dépôt successif d'une pluralité de couches minces (3, 5) sur ladite zone de la surface de ladite partie supérieure (2) du substrat (1).

10. Procédé selon l'une quelconque des revendications 1 à 9, **caractérisé en ce que** l'étape a) comporte le dépôt d'une pluralité de couches minces (7, 8) sur une pluralité de zones de la surface de la partie supérieure (2) du substrat (1).

11. Procédé selon l'une quelconque des revendications 1 à 10, **caractérisé en ce que** l'étape b) comporte le dépôt d'une pluralité de couches métalliques.

12. Procédé selon l'une quelconque des revendications 1 à 11, **caractérisé en ce que** la couche métallique (4) est constituée par des agrégats en matériau métallique.

## Claims

1. A solid phase crystallization method, **characterized in that** it comprises the following successive steps:
a) deposition of at least one thin layer (3) of amorphous or polycrystalline material on at least one area of the surface of a top part (2) of a substrate (1),
b) deposition of at least one metal layer (4) with a thickness comprised between 1nm and 20nm, advantageously between 5nm and 10nm, on an area of said thin layer (3), the top part (2) of the substrate (1) being formed, after step b), by an amorphous material able to change to a liquid or overmelted liquid state,
c) and thermal treatment to enable crystalline growth of the material of the thin layer (3), simultaneously causing:
- a temperature increase of the top part (2) of the substrate (1) at a rate of more than 100K per second until the material of the top part of the substrate goes to liquid or overmelted liquid state,
- and a heat transfer from the interface between the top part (2) of the substrate (1) and the thin layer (3) to the interface between the thin layer (3) and the metal layer (4),
an **in that** step c) is performed by application of a continuous or pulsed laser beam presenting an emission wavelength range corresponding to the absorption wavelength range of the top part (2) of the substrate (1) and to the transparency wavelength range of the amorphous or polycrystalline material of the thin layer (3) to be crystallized.

2. The method according to claim 1, **characterized in that** the absorption coefficient of the top part of the substrate is three times higher than that of the thin layer to be crystallized in the emission wavelength range of the laser beam.

3. The method according to claims 1 and 2, **characterized in that** the laser beam is obtained from a CO₂ or YAG laser source.

4. The method according to any one of claims 1 to 3, **characterized in that** a cooling step of the stack comprising the substrate, thin layer (3) and metal layer (4) is performed between steps b) and c).

5. The method according to any one of claims 1 to 4, **characterized in that** the top part (2) of the substrate (1) is amorphous before step a).

6. The method according to any one of claims 1 to 4, **characterized in that** the top part (2) of the substrate (1) being crystalline before step a), it is made amorphous after one of the two steps a) and b).

7. The method according to any one of claims 1 to 6, **characterized in that** the top part (2) of the substrate (1) is formed by a material chosen from glasses, ceramics, non-crystalline polymers, metals and metal alloys.

8. The method according to any one of claims 1 to 7, **characterized in that** the substrate (1) is entirely made of amorphous material before step c).

9. The method according to any one of claims 1 to 8, **characterized in that** step a) comprises successive deposition of a plurality of thin layers (3, 5) on said area of the surface of said top part (2) of the substrate (1).

10. The method according to any one of claims 1 to 9, **characterized in that** step a) comprises deposition of a plurality of thin layers (7, 8) on a plurality of areas of the surface of the top part (2) of the substrate (1).

11. The method according to any one of claims 1 to 10, **characterized in that** step b) comprises deposition of a plurality of metal layers.

12. The method according to any one of claims 1 to 11, **characterized in that** the metal layer (4) is formed by aggregates of metal material.

## Patentansprüche

1. Verfahren zur Kristallisierung in der Feststoff-Phase,
**dadurch gekennzeichnet,**
**dass** es die folgenden, aufeinander folgenden Verfahrensschritte umfasst:
a) Auftragen von mindestens einer dünnen Schicht (3) aus einem amorphen oder polykristallinen Werkstoff in mindestens einem Bereich der Oberfläche eines oberen Teils (2) eines Substrats (1),
b) Auftragen mindestens einer metallischen Schicht (4) mit einer Stärke, die zwischen 1 nm und 20 nm und vorzugsweise zwischen 5 nm und 10 nm liegt, in einem Bereich dieser dünnen Schicht (3), wobei der obere Teil (2) des Substrats (1) nach dem Verfahrensschritt b) von einem amorphen Werkstoff gebildet wird, der in einen flüssigen Zustand oder unterkühlt flüssigen Zustand übergehen kann,
c) und Wärmebehandlung, um das Kristallwachstum des Werkstoffs der dünnen Schicht (3) zu ermöglichen, wobei gleichzeitig gesorgt wird für:
- ein Ansteigen der Temperatur des oberen Teils (2) des Substrats (1) in einer Geschwindigkeit von mehr als 100K pro Sekunde, bis der Werkstoff des oberen Teils des Substrats in den flüssigen Zustand oder unterkühlt flüssigen Zustand übergeht,
- und einen Wärmetransfer von der Grenzfläche zwischen dem oberen Teil (2) des Substrats (1) und der dünnen Schicht (3) aus hin zu der Grenzfläche zwischen der dünnen Schicht (3) und der metallischen Schicht (4),
und **dass** der Verfahrensschritt c) unter Anwendung eines kontinuierlichen oder impulsförmigen Laserstrahls durchgeführt wird, welcher einen Sende-Wellenlängenbereich aufweist, der dem Absorptions-Wellenlängenbereich des oberen Teils (2) des Substrats (1) und dem Lichtdurchlässigkeits-Wellenlängenbereich des amorphen oder polykristallinen Werkstoffs der zu kristallisierenden dünnen Schicht (3) entspricht.

2. Verfahren nach Anspruch 1,
**dadurch gekennzeichnet,**
**dass** der Absorptionskoeffizient des oberen Teils des Substrats in dem Sende-Wellenlängenbereich des Laserstrahls um das Dreifache größer ist als der der zu kristallisierenden dünnen Schicht.

3. Verfahren nach einem der Ansprüche 1 und 2,
**dadurch gekennzeichnet,**
**dass** der Laserstrahl aus einer CO₂- oder YAG-Laserquelle kommt.

4. Verfahren nach einem der Ansprüche 1 bis 3,
**dadurch gekennzeichnet,**
**dass** zwischen den Verfahrensschritten b) und c) ein Verfahrensschritt des Abkühlens der Aufeinanderschichtung, bestehend aus dem Substrat, der dünnen Schicht (3) und der metallischen Schicht (4), durchgeführt wird.

5. Verfahren nach einem der Ansprüche 1 bis 4,
**dadurch gekennzeichnet,**
**dass** der obere Teil (2) des Substrats (1) vor dem Verfahrensschritt a) amorph ist.

6. Verfahren nach einem der Ansprüche 1 bis 4,
**dadurch gekennzeichnet,**
**dass** der obere Teil (2) des Substrats (1), wenn er vor dem Verfahrensschritt a) kristallin ist, nach einem der beiden Verfahrensschritte a) und b) amorph gemacht wird.

7. Verfahren nach einem der Ansprüche 1 bis 6,
**dadurch gekennzeichnet,**
**dass** der obere Teil (2) des Substrats (1) aus einem Werkstoff besteht, der unter den Glas-, den Keramikwerkstoffen, den nicht kristallinen Polymeren, den Metallen und den Metalllegierungen gewählt wird.

8. Verfahren nach einem der Ansprüche 1 bis 7,
**dadurch gekennzeichnet,**
**dass** das Substrat (1) vollständig aus einem vor dem Verfahrensschritt c) amorphen Werkstoff besteht.

9. Verfahren nach einem der Ansprüche 1 bis 8,
**dadurch gekennzeichnet,**
**dass** der Verfahrensschritt a) das nacheinander erfolgende Auftragen einer Mehrzahl von dünnen Schichten (3, 5) in dem genannten Bereich der Oberfläche des oberen Teils (2) des Substrats (1) umfasst.

10. Verfahren nach einem der Ansprüche 1 bis 9,
**dadurch gekennzeichnet,**
**dass** der Verfahrensschritt a) das Auftragen einer Mehrzahl von dünnen Schichten (7, 8) in einer Mehrzahl von Bereichen der Oberfläche des oberen Teils (2) des Substrats (1) umfasst.

11. Verfahren nach einem der Ansprüche 1 bis 10,
**dadurch gekennzeichnet,**
**dass** der Verfahrensschritt b) das Auftragen einer Mehrzahl von metallischen Schichten umfasst.

12. Verfahren nach einem der Ansprüche 1 bis 11,
**dadurch gekennzeichnet,**
**dass** die metallische Schicht (4) aus Aggregaten aus einem metallischen Werkstoff besteht.
